# EUROPEAN PATENT SPECIFICATION

(11) **EP 2 958 411 B1**
(45) Date of publication and mention of the grant of the patent: **15.01.2020**
(21) Application number: 14172778.4
(22) Date of filing: 17.06.2014
(51) Int. Cl.: H05K 7/14, H02M 7/00

(54) **Subsea converter device**
Unterwasserwandlervorrichtung
Dispositif convertisseur sous-marin

(43) Date of publication of application: 23.12.2015
(73) Proprietor: Siemens Aktiengesellschaft, 80333 München (DE)
(72) Inventor: Aarskog, Fredrik Gundersen, 2005, Raelingen (NO)

(56) References cited:
- EP-A1- 2 666 956
- EP-A1- 2 919 571
- WO-A1-2014/071985
- GB-A- 1 600 095
- US-A1- 2009 226 262

## Description

The present invention relates to a subsea converter device for providing an electrical power conversion. In particular, the present invention relates to a subsea converter device comprising a plurality of power cells and providing, for example, a frequency conversion of AC electric power.

### Background of the invention

In deep sea oil and gas production sites, subsea power grids may be installed for providing the required electrical power for electrical actuators like electric motors and electric pumps. For controlling an electric motor, a voltage, current or AC frequency may be varied. Therefore, for example, a variable speed drive (VSD) may be provided in the power grid comprising, for example, a transformer, a control system and plurality of power cells, wherein each power cell may vary a voltage or frequency of a single-phase or three-phase power supply. The components of the variable speed drive including the power cells may be housed in pressure compensated enclosures such that, if the device is installed in water depths of 3,000 meters or more, the components may be exposed to pressures up to or even in excess of 300 bar. For protecting the components from corrosive sea water, the pressure-compensated enclosure is sealed against the sea water, but may be configured to compensate a volume change of a fluid inside the pressure-compensated enclosure due to the high pressure at an outside of the pressure-compensated enclosure. Most components inside the variable speed drive enclosure may be located in a pressure-compensated fluid, for example, a dielectric fluid (e.g. Midel 7131) such that the electrical components will be in contact with the dielectric fluid and will be exposed to the same ambient pressure as the water pressure surrounding the subsea variable speed drive. Usually, all electrical components share the same dielectric fluid volume.

A very important design principle for a subsea variable speed drive is redundancy. For a typical variable speed drive, a plurality of power cells, for example six power cells, may be series connected in each of the three phases of the electrical power supply. However, there may be more power cells located within the variable speed drive than is strictly required to provide full output power. A power cell may have a three-phase AC input, a three-phase diode rectifier, a DC link capacitor bank, an IGBT (Insulated-Gate Bipolar Transistor) module in H-bridge configuration, and a one-phase output. However, for other drive topologies, other power cell arrangements are possible. If one of the power cells fails it may be bypassed such that the faulty part is disconnected and the remaining cells increase their output power to maintain the required total output power of the variable speed drive.

In this context, EP 2 666 956 A1 relates to a modular electric device located under water and operating under high pressure in water environment at large depths, in which electric and power electronic systems are protected against the mechanical effect of high pressure. The device is especially suitable for powering underwater oil and gas production systems. The modular electric system is placed under water in a watertight container which comprises at least one electric system which comprises modular functional electrical elements placed in a protective insulating capsule. The electric system is located in a closed container filled with a dielectric non-compressible liquid of a pressure similar to the pressure surrounding the container from external side of the container. At least one of the protective capsules contains an insulating medium of a pressure significantly lower than the pressure in the container and is furnished with means for transferring heat generated in modular functional electrical elements.

US 2009/0226262 A1 relates to an electrical power system for stationary or movable subsea loads providing one common feeder for multiple electric motors which can be individually controlled. Operational flexibility and operational safety for operation in varying water depths is provided by encapsulating an electrical functional element of a subsea power system with a subsea electrical distribution system individually or in-groups. The electrical functional element and its semi-conductor elements are arranged within at least one fluidized internal pressure casing. An external pressure casing is provided for the subsea electrical distribution system and/or other components of the subsea system. A high frequency power transmission to the subsea pressurized distribution system with pressurized semi-conductor components reduces weight and size of subsea transformers and cables employed in subsea systems.

A reliability and expected lifetime of electrical components may significantly depend on the surrounding dielectric fluid quality. The fluid quality may be influenced by a water content, an acid content and a particle content within the dielectric fluid. The reliability of the components increases significantly with improved fluid quality. Accordingly, there is need for providing improved quality of the dielectric fluid surrounding the electrical components of a subsea converter device, for example, a variable speed drive device and its contained power cells.

### Summary of the invention

According to the present invention, this object is achieved by a subsea converter device as defined in claim 1. The dependent claims define preferred and advantageous embodiments of the present invention.

According to an embodiment, a subsea converter device for providing an electrical power conversion is provided. The subsea converter device comprises a pressure-compensated device enclosure sealing an interior of the pressure-compensated device enclosure from an exterior of the pressure-compensated device enclosure. The subsea converter device comprises furthermore a plurality of converter module devices arranged within the pressure-compensated device enclosure. Each of the converter module devices comprises a corresponding pressure-compensated module enclosure sealing an interior of the pressure-compensated module enclosure from the interior of the pressure-compensated device enclosure.

The subsea converter device comprises the above-described variable speed drive and the converter module devices comprise the power cells described above. In other words, the subsea converter device has a main enclosure comprising a plurality of module enclosures arranged within the main enclosure. The module enclosures are sealed and pressure-compensated. Therefore, a fluid, for example, a dielectric fluid, contained in each module enclosure, is reliably separated from a fluid of another module enclosure and separated from a fluid of the main enclosure. When a fault occurs in one of the module enclosures or in the main enclosure, this fault may produce a significant amount of contaminations to the surrounding dielectric fluid, for example, acids and conductive particles.

The subsea converter device, especially for example the variable speed drive described above, may be designed for redundancy such that it shall be able to continue to operate even if one or more components, for example power cells, experiences a failure. To avoid that a failure in one converter module will negatively impact the reliability and expected lifetime of other converter module devices and other components of the subsea converter device, the pressure-compensated module enclosures are each sealed against an interior of the pressure-compensated device enclosure.

For example, a first dielectric fluid may be arranged in the interior of the pressure-compensated device enclosure and outside the pressure-compensated module enclosure. Furthermore, a second dielectric fluid may be arranged in the interior of at least one or all of the pressure-compensated module enclosures. If the dielectric fluid of one enclosure is contaminated, this contamination will not be distributed to the dielectric fluids of the other enclosures. Therefore, a fault in one converter module device will not negatively impact the reliability and expected lifetime of other converter module devices or components of the subsea converter device. Therefore, a full redundancy may be provided, as one failure will not increase the probability of a second failure in another device.

Furthermore, as another example, the subsea converter device may have some flanges and hatches which are sealed by any type of seal, for example, a metal seal or a polymer seal. However, any seal will have a leakage rate such that over time water will slowly diffuse from the surrounding sea water through the seal into the interior of the subsea converter device. This means that the humility content of the first fluid arranged in the interior of the pressure-compensated device enclosure and outside the pressure-compensated module enclosure will gradually increase over time leading to a reduced fluid quality and reduced lifetime and reliability of components surrounded by the first dielectric fluid. Due to the pressure-compensated module enclosures, the converter module devices will not be affected by this degradation of the fluid quality of the first dielectric fluid.

According to another embodiment, the subsea converter device comprises at least a transformer and/or a control circuit which are arranged within the interior of the pressure-compensated device enclosure and outside the pressure-compensated module enclosures. Therefore, when a failure occurs within one of the pressure-compensated module enclosures, a fluid surrounding the transformer or the control circuit will not be degraded by a contamination due to a faulty component of the pressure-compensated module enclosure.

According to another embodiment, the pressure-compensated module enclosure is made of a metal material, a carbon steel, a stainless steel, aluminium or may be at least partially from a type of polymer or elastomer or rubber. Furthermore, the pressure-compensated module enclosure may comprise a heat sink arranged at an outside surface of a wall of the pressure-compensated module enclosure. At an inside wall surface opposite to the heat sink, diodes or IGBTs may be mounted. Hence, the diodes and IGBTs are located inside the pressure-compensated module enclosure and the heat sink will effectively remove heat from these components to the outside of the pressure-compensated module enclosure, for example, to the fluid surrounding the pressure-compensated module enclosure. Furthermore, due to the metal material of the pressure-compensated module enclosure, heat from the fluid inside the pressure-compensated module enclosure will be removed effectively.

According to another embodiment, at least one of the pressure-compensated module enclosures may comprise an electrical penetrator through a wall of the pressure-compensated module enclosure providing a sealed electrical connection from the interior of the pressure-compensated module enclosure to the interior of the pressure-compensated device enclosure. For example, a three-phase AC input may penetrate the pressure-compensated module enclosure using electrical penetrators, either one penetrator with three conductors or three penetrators with one conductor each. Furthermore, two conductors of a single-phase output current may also penetrate the pressure-compensated module enclosure using electrical penetrators. The electrical connection between input penetrator, components within the converter module device, for example, a diode module and IGBTs, and the output penetrator may be done using copper bars. Furthermore, if a power cell control circuit is mounted outside the pressure-compensated module enclosure, electrical control signals to, for example the IGBTs, and some sensor signals may penetrate the pressure-compensated module enclosure via corresponding electrical penetrators. If the control circuit is mounted inside the pressure-compensated module enclosure, some electrical power wires and electrical or fibre optical control signals may need to penetrate the pressure-compensated module enclosure via corresponding electrical or fibre optical penetrators. The electrical penetrators provide an electrical connection from inside to outside of the pressure-compensated module enclosure while maintaining electrical insulation between a conductor and a wall of the pressure-compensated module enclosure and also acting as a barrier between the two sides of the wall such that an inside of the pressure-compensated module enclosure is sealed from an outside. Therefore, for example, the fluid volumes inside and outside the pressure-compensated module enclosure remain separated from each other.

Each pressure-compensated module enclosure comprises a compensator for compensating a volume change of a fluid inside the pressure-compensated module enclosure. The fluid volume inside the converter module devices is pressure-compensated, meaning that a volume change of the fluid inside the converter module device is compensated by a compensator. A volume compression may occur due to pressure increasing as the system is lowered to the sea bed, or due to a thermal expansion due to temperature change. A compensator may be made of a flexible membrane, for example metal or a polymer material, or the walls of the pressure-compensated module enclosure itself may be designed flexible enough to compensate the required volume change.

According to another embodiment, each or at least one of the pressure-compensated module enclosures comprises a sealable filling through-hole which is arranged in a wall of the pressure-compensated module enclosure and may be used for filling a fluid into the pressure-compensated module enclosure. The filling through-hole provides a fluid connection between the interior of the pressure-compensated module enclosure and an exterior of the pressure-compensated module enclosure in a non-sealed condition. In a sealed condition, the filling through-hole inhibits a fluid connection between the interior of the pressure-compensated module enclosure and the exterior of the pressure-compensated module enclosure. Additionally or as an alternative, valves for filling the fluid into the pressure-compensated module enclosure may be provided. The holes and valves will be used for fluid filling of the pressure-compensated module enclosure and are then sealed.

As described above, each converter module device may comprise, for example, an insulated-gate bipolar transistor (IGBT), a diode, a capacitor, or a control circuit or a combination of one or more of the components listed above.

Although specific features described in the above summary and the following detailed description are described in connection with specific embodiments and aspects of the present invention, it should be understood that the features of the exemplary embodiments and aspects may be combined with each other unless specifically noted otherwise.

### Brief description of the drawings

The present invention will now be described in more detail with reference to the accompanying drawings.
Fig. 1 shows schematically a subsea converter device comprising a plurality of converter module devices according to an embodiment of the present invention.
Fig. 2 shows a converter module device according to an embodiment of the present invention in more detail.

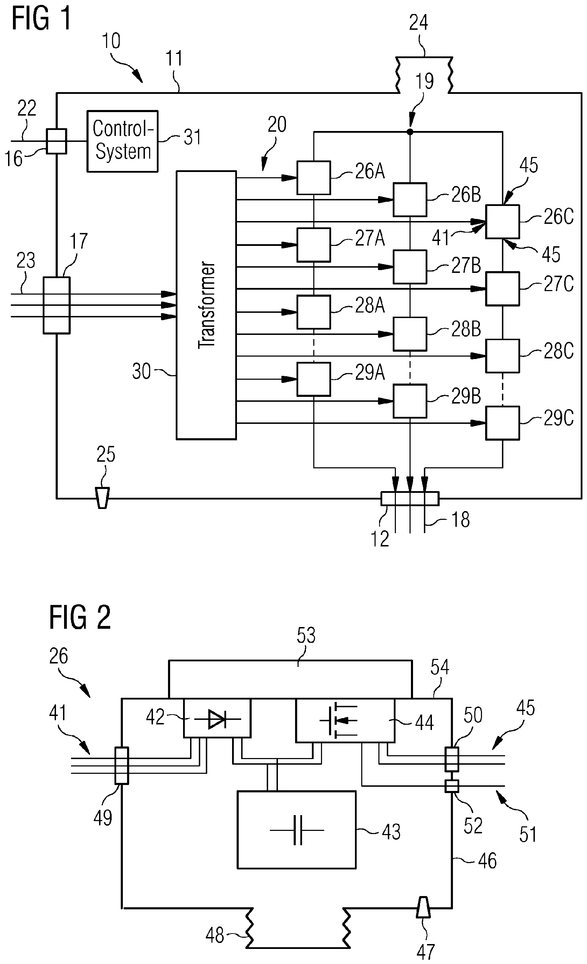

Fig. 1 shows a subsea converter device 10 to be used in subsea applications in deep sea water in a working depth of for example 1,000 to 3,000 meters which gives a surrounding sea water pressure of approximately 100 to 300 bar. The subsea converter device 10 comprises a housing 11 which is a pressure-compensated device enclosure, such that a pressure inside the enclosure corresponds approximately to the pressure outside the enclosure 11, and therefore, inside the enclosure 11, a pressure of approximately 100 to 300 bar may be present. The pressure-compensated device enclosure 11 may comprise electrical penetrators 12, 16 and 17 for providing electrical connections between components inside the pressure-compensated device enclosure 11 and other subsea devices via electrical connections 18, 22 and 23. Furthermore, the penetrators 12, 16 and 17 may provide a passing of other connections between the interior of the pressure-compensated device enclosure 11 and other subsea devices, for example optical fibre communication connections or fluid communication connections. For compensating a pressure inside the pressure-compensated device enclosure 11 and an outside, a compensator 24 may be provided, for example a flexible membrane of metal or polymer material, or the walls of the enclosure 11 itself may be made flexible such that a required volume change may be compensated. A filling hole 25, which may be sealed by a plug or a valve, may be provided for filling the interior of the pressure-compensated device enclosure 11 with for example a fluid, for example, a dielectric fluid.

The subsea converter device 11 may comprise, for example, a variable speed drive (VSD) comprising a plurality of converter module devices 26A, 26B, 26C, 27A, 27B, 27C, 28A, 28B, 28C, 29A, 29B and 29C, a transformer 30 and a control system 31. In the following, the reference signs 26A, 26B, 26C, 27A, 27B, 27C, 28A, 28B, 28C, 29A, 29B and 29C of the converter module devices will be abbreviated by 26-29 where appropriate. Each converter module device 26-29 may comprise, for example, a power cell which will be described in more detail in connection with Fig. 2. The connection 23 may provide a three-phase high voltage input to the transformer 30, and the transformer may transform this high voltage into three-phase low voltages 20 provided to each power cell 26-29. Each power cell 26-29 may received the electrical power from the transformer 30 at a corresponding input 41, may process the electrical power, and may output a processed electrical power at outputs 45. One line of the outputs 45 may be coupled to a neutral point 19.

Reliability of a subsea equipment is very important and therefore, a redundant design principle may be realized. For example, the VSD may comprise more power cells than strictly required to provide the required output power. If some of the power cells fail, it can be bypassed such that the faulty parts are disconnected and the remaining power cells increase their output power to maintain a constant total VSD output power.

The interior of the pressure-compensated device enclosure 11 may be filled with a dielectric fluid for cooling and isolating the components inside the enclosure 11. Furthermore, the converter module devices 26 to 29 are each filled with a dielectric fluid for the same reasons. Reliability and expected lifetime of electrical components surrounded by the dielectric fluid may significantly depend on a quality of the surrounding dielectric fluid. The quality of the fluid may depend on a water content, an acid content and a particle content. The reliability increases significantly with improved fluid quality. If a component fails, for example, a capacitor or a semiconductor component, the dielectric fluid surrounding this component may be deteriorated due to acids of the capacitor or particles from a destroyed semiconductor. Therefore, each of the converter module devices 26 to 29 comprises an own pressure-compensated device enclosure separating the dielectric fluid inside of each of the converter module devices 26 to 29 from the fluid inside the pressure-compensated device enclosure 11.

Fig. 2 shows as an example one of the converter module devices 26-29 in more detail. The exemplary converter module device of Fig. 2 is designated with reference sign 26 and may represent any one of the converter module devices 26 to 29. The converter module device 26 may comprise a power cell comprising the three-phase AC input 41, a three-phase diode rectifier 42, a DC link capacitor bank 43, an insulated-gate bipolar transistor (IGBT) module 44 in for example an H-bridge configuration, and the one-phase output 45. However, for other topologies, other power cell arrangements may be implemented. The converter module device 26 comprises a pressure-compensated module enclosure 46 sealing an interior of the pressure-compensated module enclosure 46 from the interior of the pressure-compensated device enclosure 11, when the converter module device 26 is arranged within the subsea converter device 10 as shown in Fig. 1. The interior of the pressure-compensated module enclosure 46 is filled with a dielectric fluid. For filling the dielectric fluid into the pressure-compensated module enclosure 46, a filling hole 47 may be provided which may be sealed by a valve or a plug after filling the dielectric fluid into the enclosure 46. The fluid volume inside the pressure-compensated module enclosure 46 is pressure-compensated. Therefore, a volume change of the fluid inside the enclosure 46, for example because of a volume compression due to pressure increasing as the system is lowered to the sea bed or due to a thermal expansion due to a temperature change, is compensated by a compensator 48. The compensator 48 may be made of a flexible membrane of for example a metal or a polymer material, or the walls of the enclosure 46 may be made flexible enough to compensate the required volume change. For passing the three-phase AC input 41 from an exterior to an interior of the enclosure 46, a penetrator or a plurality of penetrators 49 is provided. For passing the single-phase output 45, a further penetrator 50 is provided. The converter module device 26 may comprise, furthermore, a (not shown) control circuit for controlling the IGBT 44. Additionally or as an alternative, the IGBT 44 may be directly controlled via a corresponding control connection 51 which is passed through a wall of the enclosure 46 via a further penetrator 52.

The rectifier 42 and the IGBT module 44 may generate heat in operation. For dissipating this heat, the rectifier 42 as well as the IGBT module 44 may be arranged at an inside surface of a wall 54 of the enclosure 46 and a heat sink 53 may be arranged at an opposite outside surface of the wall 54. The enclosure 46 may be made at least partly of a metal material like, for example, stainless steel or aluminium such that the heat from the rectifier 42 and the IGBT module 44 may be conducted through the wall 54 to the heat sink 53.

In case one of the converter module devices 26 to 29 of Fig. 1 fails, for example, due to a breakdown of the rectifier 42, the IGBT module 44 or the capacitor bank 43, only the fluid within the corresponding converter module device is contaminated with particles or acid from the broken component and the fluid within the pressure-compensated device enclosure 11 and the fluid within the other converter module devices is not contaminated. Thus, a reliability of, for example, the control system 41, the transformer 30 and the other converter module devices may be maintained.

To sum up, in the above-described subsea converter device 10, for example, a variable speed drive, the IGBTs, diodes and DC-link capacitors are located in a fluid volume that is not in contact with the main fluid volume of the VSD. This means that if one power cell fails, the resulting contaminants will not spread into the main VSD fluid volume and thereby not reduce the lifetime of other components located there, such as a main control system 31, a main transformer 30 and (not shown) auxiliary equipment. Further, contaminants that could appear in the main fluid volume will not enter the power cell enclosures and thereby not negatively affect their reliability and lifetime. Therefore, the design shown in Fig. 1 results in a true redundancy. Furthermore, the fluid quality of the fluid inside the power cell enclosure 46 may be conditioned to a better state than the fluid inside the enclosure 11, as the volume in enclosure 11 may be very large and may be exposed to air, dust and humidity for a longer period of time before it can be sealed. Additionally, it may be more difficult to dry the internals of the enclosure 11 as it is possible for the components of the converter module devices 26 to 29, because the module enclosure 46 is smaller, has less components, and because the components inside the enclosure 46 may, in general, tolerate higher temperatures than other components of the subsea converter device 10, for example, the control system 31. Also, the device enclosure 11 is much larger than the module enclosures 46 and a lot more sealings and penetrators may be present at the device enclosure 11 than at the module enclosure 46. Therefore, a risk of water leakage and diffusion through the sealings over time is more probable at the device enclosure 11.

Testing has revealed that the three components that are most sensitive to a dielectric fluid contamination are the capacitor 43, the IGBTs 44 and the rectifier 42. Therefore, a separate pressure-compensated module enclosure 46, which is sealed from an interior of the device enclosure 11, may contribute to provide a more secure fluid environment for these components and may increase reliability.

The design of the enclosure 46 shown in Fig. 2 may utilize materials that have already passed a long-term material compatibility testing with the electric fluids, for example, Midel fluid. The mechanical strength of the enclosure 46 can be made high since it may be made of a metal material. This may improve shock and vibration test results. The whole module enclosure 46 may be electrically conductive and may be kept at a local ground voltage level and therefore, electromagnetic emissions (EMI) will be low. Furthermore, a wiring running along local ground may automatically be more shielded from electromagnetic noise. By separating the fluids of the enclosures 46 and the enclosure 11, the converter module device 26 may be constructed, dried and fluid-filled in a very short time. It may then be stored and/or transported in this very favourable condition until it is mounted in the subsea converter device 10. This will protect the components of the converter module device 26 from contaminations like particles, humidity and oxygen, and will positively impact a lifetime and reliability. For example, no special transportation and storage boxes may be needed. The enclosure 46 may provide a smooth outer metal surface which is easy to clean as it is completely sealed. Cleaning may be needed before mounting the enclosure 46 into the enclosure 11. Furthermore, the design shown in Fig. 1 allows the use of different types of dielectric fluids inside the converter module devices 26 to 29 and inside the volume of the enclosure 11.

## Claims

1. A subsea converter device for providing an electrical power conversion, comprising:
- a pressure compensated device enclosure (11) sealing an interior of the pressure compensated device enclosure (11) from an exterior of the pressure compensated device (11) enclosure, and
- a plurality of converter module devices (26-29) arranged within the pressure compensated device enclosure (11), **characterized in that**
each of the converter module devices (26-29) comprises a corresponding pressure compensated module enclosure (46) sealing an interior of the pressure compensated module enclosure (46) from the interior of the pressure compensated device enclosure (11), wherein the pressure compensated module enclosure (46) comprises a compensator (48) for compensating a volume change of a pressure compensated fluid inside the pressure compensated module enclosure (46),
and that the subsea converter device (10) comprises a subsea variable speed drive, each converter module device (26-29) comprising a power cell of the variable speed drive.

2. The subsea converter device according to claim 1, further comprising at least one component of a group comprising:
- a transformer (30), and
- a control circuit (31),
wherein the at least one component is arranged in the interior of the pressure compensated device enclosure (11) and outside the pressure compensated module (46) enclosures.

3. The subsea converter device according to claim 1 or 2, further comprising at least one fluid of a group comprising:
- a first dielectric fluid arranged in the interior of the pressure compensated device enclosure (11) and outside the pressure compensated module enclosures (46), and
- a second dielectric fluid arranged in the interior of at least one of the pressure compensated module enclosures (46).

4. The subsea converter device according to any one of the preceding claims, wherein at least one of the pressure compensated module enclosures (46) is made of at least one material of a group comprising:
- metal,
- carbon steel,
- stainless steel,
- aluminium,
- a polymer,
- an elastomer, and
- rubber.

5. The subsea converter device according to any one of the preceding claims, wherein at least one of the pressure compensated module enclosures (46) comprises a heat sink (53) arranged at an outside surface of a wall (54) of the pressure compensated module enclosure (46).

6. The subsea converter device according to any one of the preceding claims, wherein at least one of the pressure compensated module enclosures (46) comprises an electrical penetrator (49, 50, 52) through a wall of the pressure compensated module enclosure (46) providing a sealed electrical connection (41, 45, 51) from the interior of the pressure compensated module enclosure (46) to the interior of the pressure compensated device enclosure (11).

7. The subsea converter device according to any one of the preceding claims, wherein at least one of the pressure compensated module enclosures (46) comprises a sealable filling through hole (47) arranged in a wall of the pressure compensated module enclosure (46) for filling a fluid into the pressure compensated module enclosure (46), the filling through hole (47) providing a fluid connection between the interior of the pressure compensated module enclosure (46) and an exterior of the pressure compensated module enclosure (46) in a non-sealed condition and inhibiting a fluid connection between the interior of the pressure compensated module enclosure (46) and the exterior of the pressure compensated module (46) enclosure in a sealed condition.

8. The subsea converter device according to any one of the preceding claims, wherein the converter module device (26-29) comprises at least one component of a group comprising:
- an insulated-gate bipolar transistor (44),
- a diode (42),
- a capacitor (43), and
- a control circuit.

## Patentansprüche

1. Unterwasserwandlervorrichtung zum Bereitstellen einer elektrischen Leistungswandlung, umfassend:
- ein druckkompensiertes Vorrichtungsgehäuse (11), das ein Inneres des druckkompensierten Vorrichtungsgehäuses (11) gegenüber einer Außenseite des druckkompensierten Vorrichtungsgehäuses (11) abdichtet, und
- mehrere Wandlermodulvorrichtungen (26-29), die innerhalb des druckkompensierten Vorrichtungsgehäuses (11) angeordnet sind,
**dadurch gekennzeichnet, dass**
jede der Wandlermodulvorrichtungen (26-29) ein entsprechendes druckkompensiertes Modulgehäuse (46) umfasst, das ein Inneres des druckkompensierten Modulgehäuses (46) gegenüber dem Inneren des druckkompensierten Vorrichtungsgehäuses (11) abdichtet, wobei das druckkompensierte Modulgehäuses (46) einen Kompensator (48) zum Ausgleichen einer Volumenänderung eines druckkompensierten Fluids innerhalb des druckkompensierten Modulgehäuses (46) umfasst,
und dass die Unterwasserwandlervorrichtung (10) einen unterseeischen drehzahlveränderlichen Antrieb umfasst, wobei jede Wandlermodulvorrichtung (26-29) eine Leistungszelle des drehzahlveränderlichen Antriebs umfasst.

2. Unterwasserwandlervorrichtung nach Anspruch 1, welche ferner wenigstens eine Komponente aus einer Gruppe umfasst, welche umfasst:
- einen Transformator (30) und
- eine Steuerschaltung (31),
wobei die wenigstens eine Komponente im Inneren des druckkompensierten Vorrichtungsgehäuses (11) und außerhalb der druckkompensierten Modulgehäuse (46) angeordnet ist.

3. Unterwasserwandlervorrichtung nach Anspruch 1 oder 2, welche ferner wenigstens ein Fluid aus einer Gruppe umfasst, welche umfasst:
- ein erstes dielektrisches Fluid, das im Inneren des druckkompensierten Vorrichtungsgehäuses (11) und außerhalb der druckkompensierten Modulgehäuse (46) angeordnet ist, und
- ein zweites dielektrisches Fluid, das im Inneren wenigstens eines der druckkompensierten Modulgehäuse (46) angeordnet ist.

4. Unterwasserwandlervorrichtung nach einem der vorhergehenden Ansprüche, wobei wenigstens eines der druckkompensierten Modulgehäuse (46) aus wenigstens einem Material aus einer Gruppe hergestellt ist, welche umfasst:
- Metall,
- Kohlenstoffstahl,
- nichtrostenden Stahl,
- Aluminium,
- ein Polymer,
- ein Elastomer und
- Gummi.

5. Unterwasserwandlervorrichtung nach einem der vorhergehenden Ansprüche, wobei wenigstens eines der druckkompensierten Modulgehäuse (46) eine Wärmesenke (53) umfasst, die an einer Außenfläche einer Wand (54) des druckkompensierten Modulgehäuses (46) angeordnet ist.

6. Unterwasserwandlervorrichtung nach einem der vorhergehenden Ansprüche, wobei wenigstens eines der druckkompensierten Modulgehäuse (46) eine elektrische Durchführung (49, 50, 52) durch eine Wand des druckkompensierten Modulgehäuses (46) umfasst, die eine abgedichtete elektrische Verbindung (41, 45, 51) vom Inneren des druckkompensierten Modulgehäuses (46) zum Inneren des druckkompensierten Vorrichtungsgehäuses (11) gewährleistet.

7. Unterwasserwandlervorrichtung nach einem der vorhergehenden Ansprüche, wobei wenigstens eines der druckkompensierten Modulgehäuse (46) ein abdichtbares Einfüll-Durchgangsloch (47), das in einer Wand des druckkompensierten Modulgehäuses (46) angeordnet ist, zum Einfüllen eines Fluids in das druckkompensierte Modulgehäuse (46) umfasst, wobei das Einfüll-Durchgangsloch (47) in einem nicht abgedichteten Zustand eine Fluidverbindung zwischen dem Inneren des druckkompensierten Modulgehäuses (46) und einer Außenseite des druckkompensierten Modulgehäuses (46) bereitstellt und in einem abgedichteten Zustand eine Fluidverbindung zwischen dem Inneren des druckkompensierten Modulgehäuses (46) und der Außenseite des druckkompensierten Modulgehäuses (46) verhindert.

8. Unterwasserwandlervorrichtung nach einem der vorhergehenden Ansprüche, wobei die Wandlermodulvorrichtung (26-29) wenigstens eine Komponente aus einer Gruppe umfasst, welche umfasst:
- einen Bipolartransistor mit isoliertem Gate (44),
- eine Diode (42),
- einen Kondensator (43) und
- eine Steuerschaltung.

## Revendications

1. Dispositif convertisseur sous-marin pour fournir une conversion d'énergie électrique, comprenant :
- une enceinte de dispositif compensée en pression (11) rendant étanche un intérieur de l'enceinte de dispositif compensée en pression (11) vis-à-vis d'un extérieur de l'enceinte de dispositif compensée en pression (11), et
- une pluralité de dispositifs à module convertisseur (26-29) agencés à l'intérieur de l'enceinte de dispositif compensée en pression (11),
**caractérisé en ce que**
chacun des dispositifs à module convertisseur (26-29) comprend une enceinte de module compensée en pression (46) correspondante rendant étanche un intérieur de l'enceinte de module compensée en pression (46) vis-à-vis de l'intérieur de l'enceinte de dispositif compensée en pression (11), dans lequel l'enceinte de module compensée en pression (46) comprend un compensateur (48) pour compenser une variation de volume d'un fluide compensé en pression à l'intérieur de l'enceinte de module compensée en pression (46),
et **en ce que** le dispositif convertisseur sous-marin (10) comprend un élément d'entraînement à vitesse variable sous-marin, chaque dispositif à module convertisseur (26-29) comprenant une cellule d'énergie de l'élément d'entraînement à vitesse variable.

2. Dispositif convertisseur sous-marin selon la revendication 1, comprenant en outre au moins un composant d'un groupe comprenant :
- un transformateur (30), et
- un circuit de commande (31),
dans lequel l'au moins un composant est agencé dans l'intérieur de l'enceinte de dispositif compensée en pression (11) et à l'extérieur des enceintes de module compensées en pression (46).

3. Dispositif convertisseur sous-marin selon la revendication 1 ou 2, comprenant en outre au moins un fluide d'un groupe comprenant :
- un premier fluide diélectrique agencé dans l'intérieur de l'enceinte de dispositif compensée en pression (11) et à l'extérieur des enceintes de module compensées en pression (46), et
- un second fluide diélectrique agencé dans l'intérieur d'au moins l'une des enceintes de module compensées en pression (46).

4. Dispositif convertisseur sous-marin selon l'une quelconque des revendications précédentes, dans lequel au moins l'une des enceintes de module compensées en pression (46) est constituée d'au moins un matériau d'un groupe comprenant :
- un métal,
- un acier au carbone,
- un acier inoxydable,
- un aluminium,
- un polymère,
- un élastomère,
- et un caoutchouc.

5. Dispositif convertisseur sous-marin selon l'une quelconque des revendications précédentes, dans lequel au moins l'une des enceintes de module compensées en pression (46) comprend un dissipateur thermique (53) agencé sur une surface extérieure d'une paroi (54) de l'enceinte de module compensée en pression (46).

6. Dispositif convertisseur sous-marin selon l'une quelconque des revendications précédentes, dans lequel au moins l'une des enceintes de module compensées en pression (46) comprend un pénétrateur électrique (49, 50, 52) à travers une paroi de l'enceinte de module compensée en pression (46) fournissant une connexion électrique étanche (41, 45, 51), de l'intérieur de l'enceinte de module compensée en pression (46) à l'intérieur de l'enceinte de dispositif compensée en pression (11).

7. Dispositif convertisseur sous-marin selon l'une quelconque des revendications précédentes, dans lequel au moins l'une des enceintes de module compensées en pression (46) comprend un trou traversant de remplissage apte à être scellé (47) agencé dans une paroi de l'enceinte de module compensée en pression (46) pour le remplissage d'un fluide dans l'enceinte de module compensée en pression (46), le trou traversant de remplissage (47) fournissant une liaison par fluide entre l'intérieur de l'enceinte de module compensée en pression (46) et un extérieur de l'enceinte de module compensée en pression (46) dans un état non-étanche et inhibant une liaison par fluide entre l'intérieur de l'enceinte de module compensée en pression (46) et l'extérieur de l'enceinte de module compensée en pression (46) dans un état étanche.

8. Dispositif convertisseur sous-marin selon l'une quelconque des revendications précédentes, dans lequel le dispositif à module convertisseur (26-29) comprend au moins un composant d'un groupe comprenant :
- un transistor bipolaire à grille isolée (44),
- une diode (42),
- un condensateur (43), et
- un circuit de commande.
